# EUROPEAN PATENT SPECIFICATION

(11) **EP 2 791 072 B1**
(45) Date of publication and mention of the grant of the patent: **11.05.2016**
(21) Application number: 12812438.5
(22) Date of filing: 07.12.2012
(51) Int. Cl.: C03C 17/245, C03C 17/34

(54) **METHOD OF FORMING OPTOELECTRONIC DEVICE HAVING A STABILIZED METAL OXIDE LAYER**
VERFAHREN ZUR HERSTELLUNG EINER OPTOELEKTRONISCHEN VORRICHTUNG MIT STABILISIERTER METALLOXIDSCHICHT
PROCÉDÉ DE FORMATION DE DISPOSITIF OPTOÉLECTRONIQUE AYANT UNE COUCHE D'OXYDE MÉTALLIQUE STABILISÉE

(30) Priority: 15.12.2011 US 201161570954 P
(43) Date of publication of application: 22.10.2014
(73) Proprietor: Dow Global Technologies LLC, Midland, MI 48674 (US)
(72) Inventor: MALEK, Andrzej M., Midland, MI 48642 (US); BRYDEN, Todd R., 40223 Dusseldorf (DE); LEBARON, Peter C., Hope, MI 48628 (US)
(74) Representative: Beck Greener
(86) International application number: PCT/US2012/068354
(87) International publication number: WO 2013/090131

(56) References cited:
- EP-A2- 0 743 686
- WO-A1-2012/001689
- WO-A2-2011/137216
- JP-A- H 114 009
- US-A1- 2006 057 766

## Description

### Field of the Invention

This invention relates to a method of treating a metal oxide layer which is part of an optoelectronically active device, such as a photovoltaic device or organic light emitting diode. The invention also relates to the device formed using this method.

### Background of the Invention

Photovoltaic devices are made with materials that absorb incident light and generate an electric output. Examples of such optoelectrically active materials include Group IB-IIIB chalcogenides, crystalline and/or amorphous silicon, cadmium tellurides, gallium arsenides, and the like. Some of these devices may be made with a metal oxide layer above the optoelectrically active material. The metal oxides serve as a conductor or semiconductor and are selected due to their transparency to light. Metal oxides are also used in organic light emitting diodes as top side electrodes. Zinc oxides are frequently used, particularly in Group IB-IIIB chalcogenide based photovoltaic cells.

US2007/0295390 teaches that metal oxides such as zinc oxides can be useful as protective layers.

### Summary of the Invention

Surprisingly, contrary to the teachings of US2007/0295390, the present inventors have discovered zinc oxides can be susceptible to reaction with moisture that can decrease long term stability of the devices. This reaction can be accelerated by the presence of even a weak acid.

Therefore, the inventors have further discovered that reaction of the metal oxide layers with certain materials can reduce susceptibility of the metal oxide layers to water and make the optoelectrically active devices more stable over time.

Thus, according to a first embodiment, this invention is a method comprising depositing a metal oxide layer as part of the production of an optoelectrically active device and exposing the metal oxide layer to a reactive agent to form a relatively hydrophobic surface.

According to a second embodiment, this invention is an optoelectrically active device having at least a back electrode, one optoelectrically active layer, and a metal oxide over the optoelectrically active layer, wherein a top portion of the metal oxide layer comprises the reaction product of the metal oxide with a compound that increases the resistance of the metal oxide layer to moisture while having substantially no effect on the optical or electrical properties of the layer.

### Brief Description of the Drawings

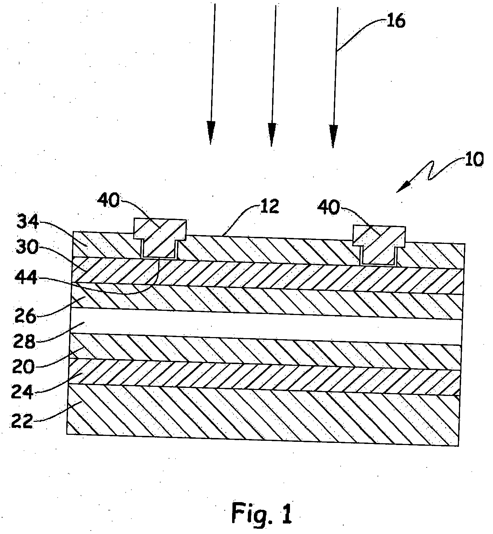

Fig. 1 is a schematic of one embodiment of a photovoltaic cell with which the present invention is useful.

### Detailed Description of the Invention

The optoelectrically active device of this invention may be any such device, such as an organic light emitting diode or, more preferably, a photovoltaic device. The device is characterized by a backside (away from light emission or light reception) electrode, at least one photoelectrically active layer, and a metal oxide over the photoelectrically active layer. The metal oxide may serve as a frontside electrode or may be an intermediate layer used in combination with an additional frontside electrode.
The metal oxide layer preferably is doped or undoped zinc oxide or a doped or undoped tin oxide (e.g. indium tin oxide), but is more preferably a zinc oxide layer such as zinc oxide, doped zinc oxides (e.g. aluminum doped zinc oxide, gallim doped zinc oxide or indium doped zinc oxide).

When the device is an organic light emitting diode, the active layer may be any small molecule or polymeric material that emits light when an electric current is applied to the material. Preferably, the device is a photovoltaic cell of the classes described above. The photovoltaic cell includes a backside electrode, an absorber and at least one metal oxide, preferably zinc oxide based, layer. Group IB-IIIB chalcogenides are the preferred absorber. These compositions shall be collectively referred to hereinafter as photoelectronically active, chalcogen-based (PACB) compositions.

Fig. 1 shows one embodiment of a photovoltaic article 10 that may be made by processes of the invention. This article 10 comprises a substrate incorporating a support 22, a backside electrical contact 24, and a chalcogenide absorber 20. The article 10 further includes a buffer region 28 incorporating an n-type chalcogenide composition of the present invention, an optional front side electrical contact window region 26, a transparent conductive region 30, a collection grid 40, and an optional barrier region 34 to help protect and isolate the article 10 from the ambient conditions. Each of these components is shown in Fig. 1 as including a single layer, but any of these independently can be formed from multiple sublayers as desired. Additional layers (not shown) conventionally used in photovoltaic cells as presently known or hereafter developed may also be provided. As used occasionally herein, the top 12 of the cell is deemed to be that side which receives the incident light 16. The method of forming the cadmium sulfide based layer on the absorber can also be used in tandem cell structures where two cells are built on top of each other each with an absorber that absorbs radiation at different wavelengths.

The support 22 may be a rigid or flexible substrate. Support 22 may be formed from a wide range of materials. These include glass, quartz, other ceramic materials, polymers, metals, metal alloys, intermetallic compositions, paper, woven or nonwoven fabrics, combinations of these, and the like. Stainless steel is preferred. Flexible substrates are preferred to enable maximum utilization of the flexibility of the thin film absorber and other layers.

The backside electrical contact 24 provides a convenient way to electrically couple article 10 to external circuitry. Contact 24 may be formed from a wide range of electrically conductive materials, including one or more of Cu, Mo, Ag, Al, Cr, Ni, Ti, Ta, Nb, W combinations of these, and the like. Conductive compositions incorporating Mo are preferred. The backside electrical contact 24 may also help to isolate the absorber 20 from the support 22 to minimize migration of support constituents into the absorber 20. For instance, backside electrical contact 24 can help to block the migration of Fe and Ni constituents of a stainless steel support 22 into the absorber 20. The backside electrical contact 24 also can protect the support 22 such as by protecting against Se if Se is used in the formation of absorber 20.

The absorber 20 preferably incorporates at least one p-type Group 1b-IIIb chalcogenide, such as selenides, sulfides, and selenides-sulfides that include at least one of copper, indium, and/or gallium. In many embodiments, these materials are present in polycrystalline form. Advantageously, these materials exhibit excellent cross-sections for light absorption that allow absorber 20 to be very thin and flexible. In illustrative embodiments, a typical absorber region 20 may have a thickness in the range from about 300 nm to about 3000 nm, preferably about 1000 nm to about 2000 nm.

Representative examples of such p-type chalcogenides absorbers are selenides, sulfides, tellurides, and/or combinations of these that include at least one of copper, indium, aluminum, and/or gallium. More typically at least two or even at least three of Cu, In, Ga, and Al are present. Sulfides and/or selenides are preferred. Some embodiments include sulfides or selenides of copper and indium. Additional embodiments include selenides or sulfides of copper, indium, and gallium. Aluminum may be used as an additional or alternative metal, typically replacing some or all of the gallium. Specific examples include but are not limited to copper indium selenides, copper indium gallium selenides, copper gallium selenides, copper indium sulfides, copper indium gallium sulfides, copper gallium selenides, copper indium sulfide selenides, copper gallium sulfide selenides, copper indium aluminum sulfide, copper indium aluminum selenide, copper indium aluminum sulfide selenide, copper indium aluminum gallium sulfide, copper indium aluminum gallium selenide, copper indium aluminum gallium sulfide selenide, and copper indium gallium sulfide selenides. The absorber materials also may be doped with other materials, such as Na, Li, or the like, to enhance performance. In addition, many chalcogen materials could incorporate at least some oxygen as an impurity in small amounts without significant deleterious effects upon electronic properties. One preferred class of CIGS materials may be represented by the formula:

CuₐIn_{b}Ga_{c}Al_{d}Se_{w}SₓTe_{y}Na_{z} (A)

Wherein, if "a" is defined as 1, then:
"(b+c+d)/a" = 1.0 to 2.5, preferably 1.0 to 1.65
"b" is 0 to 2, preferably 0.8 to 1.3
"c" is 0 to 0.5, preferably 0.05 to 0.35
"d" is 0 to 0.5, preferably 0.05 to 0.35, preferably d = 0
"(w+x+y)" is 2 to 3, preferably 2 to 2.8
"w" is 0 or more, preferably at least 1 and more preferably at least 2 to 3
"x" is 0 to 3, preferably 0 to 0.5
"y" is 0 to 3, preferably 0 to 0.5
"z" is 0 to 0.5, preferably 0.005 to 0.02

The absorber 20 may be formed by any suitable method using a variety of one or more techniques such as evaporation, sputtering, electrodeposition, spraying, and sintering. One preferred method is co-evaporation of the constituent elements from one or more suitable sources (e.g. sputter targets), where the individual constituent elements are thermally evaporated on a hot surface coincidentally at the same time, sequentially, or a combination of these to form absorber 20. After deposition, the deposited materials may be subjected to one or more further treatments to finalize the absorber properties.

Optional layers (not shown) may be used on substrate in accordance with conventional practices now known or hereafter developed to help enhance adhesion between backside electrical contact 24 and the support 22 and/or between backside electrical contact 24 and the absorber region 20. Additionally, one or more barrier layers (not shown) also may be provided over the backside of support 22 to help isolate device 10 from the ambient and/or to electrically isolate device 10.

A buffer region 28 is preferably cadmium sulfide based material deposited on the absorber 20. The buffer region may be formed by any known method including chemical bath deposition or sputtering.

Optional window region 26 which may be a single layer or formed from multiple sublayers, which can help to protect against shunts. Window region 26 also may protect buffer region 28 during subsequent deposition of the TC region 30. The window region 26 may be formed from a wide range of materials and often is formed from a resistive, transparent oxide (TCO) such as an oxide of Zn, In, Cd, Sn, combinations of these and the like. An exemplary window material is intrinsic ZnO. A typical window region 26 may have a thickness in the range from about 1 nm to about 200 nm, preferably about 10 nm to about 150 nm, more preferably about 80 to about 120 nm.

The TCO region 30, which may be a single layer or formed from multiple sublayers, is electrically coupled to the buffer region 28 to provide a top conductive electrode for article 10. In many suitable embodiments, the TCO region 30 has a thickness of at least 10 nm, preferably at least 50 nm and more preferably at least 100 nm and less than 1500 nm, preferably less than 500 nm. As shown, the TCO region 30 is in direct contact with the window region 26, but one or more intervening layers optionally may be interposed for a variety of reasons such as to promote adhesion, enhance electrical performance, or the like.

A wide variety of transparent conducting oxides; very thin conductive, transparent metal films; or combinations of these may be used in forming the transparent conductive region 30. Transparent conductive oxides are preferred. Examples of such TCOs include fluorine-doped tin oxide, tin oxide, indium oxide, indium tin oxide (ITO), aluminum doped zinc oxide (AZO), zinc oxide, combinations of these, and the like. In one illustrative embodiment, TCO region 30 has a dual layer construction in which a first sublayer proximal to the buffer incorporates zinc oxide and a second sublayer incorporates ITO and/or AZO. TCO layers are conveniently formed via sputtering or other suitable deposition technique.

The treatment of the metal oxide layer may occur in either or both of the optional window layer and the transparent conductor, but the surface treatment is preferably performed on the top or exposed surface.

The top portion of the metal oxide layer is treated in this invention by exposure to a compound that increases the resistance of the metal oxide to reaction with moisture. Preferably the treated metal oxide layer is a zinc oxide or aluminum doped zinc oxide. The surface treatment is exposure to a reactive gas or other material that reacts at the surface and thereby inhibits reaction of the metal oxide with moisture while substantially maintaining the electrical and optical properties of the overall metal oxide layer. The preferred reactive gasses are hydrogen sulfide or hydrogen selenide but other materials such as volatile organic compounds of sulfur or selenium could be used. For example volatile thiols (R-SH) or seleols (R-she), sulfides (R-S-R) or selenides (R-Se-R), where R denotes organic functionality. The use of reactive gases such as H2S or H2Se is preferred to avoid any residual carbon contamination. For H2S and H2Se the surface treatment preferably occurs by exposing the TCO to the reactive gases at pressures form 0.01 mbar to 1 bar, preferably from 0.05 mbar to 0.2 mbar of gas for a time period sufficient to affect top layer conversion ranging from 1 second to 30 minutes, preferably for 10 seconds to 60 seconds at temperatures in the range of 0°C to 250°C, preferably 25°C to 150°C.

According to a preferred embodiment the reactive compound is hydrogen sulfide or hydrogen selenide and the resulting metal oxide shows a molar ratio of metal to oxygen at a depth of 5 nm is less than 0.8, preferably no greater than 0.7, but greater than 0.2, as measured by angle resolved x-ray photoelectron spectroscopy (XPS), indicating a decrease in the amount of available oxygen for reaction at the surface. In addition, preferably the ratio of sulfur or selenium to metal (depending upon which gas is used) at 5 nm is at least 0.1, more preferably at least 0.3, and most preferably at least 0.5 indicating surface reaction of the reactive gas.

Alternatively, the depth of reaction of the surface treatment as indicated by secondary ion-mass spectrometry (SIMS)>> using 1 keV cesium sputter beam preferably is found primarily in the top 20 nm, more preferably the top 10 nm, and most preferably 5 nm as indicated by residual signal of the reactive species in the film (e.g. Se or S). At depths greater than these ranges the bulk film is preferably substantially unchanged by the surface treatment, although a very small signal of residual reactive species may still be observed at less than 1 percent.

The optional electrical grid collection structure 40 may be deposited over the TCO region 30 to reduce the sheet resistance of this layer. The grid structure 40 preferably incorporates one or more of Ag, Al, Cu, Cr, Ni, Ti, Ta, TiN, TaN, and combinations thereof. Preferably the grid is made of Ag. An optional film of Ni (not shown) may be used to enhance adhesion of the grid structure to the TCO region 30. This structure can be formed in a wide variety of ways, including being made of a wire mesh or similar wire structure, being formed by screen-printing, ink-jet printing, electroplating, photolithography, and metallizing thru a suitable mask using any suitable deposition technique.

A chalcogenide based photovoltaic cell may be rendered less susceptible to moisture related degradation via direct, low temperature application of suitable barrier protection 34 to the top of the photovoltaic article 10. The barrier protection may be a single layer or multiple sublayers. As shown the barrier does not cover the electrical grid structure but a barrier that covered such grid may be used instead or in addition to the barrier shown.

### Example

### Example 1

Samples of a stack of intrinsic ZnO and 2 wt% Al-doped ZnO films were deposited by radio frequency sputtering. Specifically, 150 nm of i-ZnO film was deposited first using 100 W, ~ 0.25% 02 (balance Ar) at a pressure of ~ 0.003 mbar. The ~ 230 nm thick Al-doped ZnO film was then deposited at 100 W, 100% Ar at a pressure of ~ 0.003 mbar. The films were deposited on borosilicate glass at a substrate temperature of ~ 150°C.

Without exposing these films to ambient conditions, the films were then reacted with either H2S or H2Se at a pressure of 0.1 mbar and two different substrate temperatures: ~ 25°C and ~ 140°C. X-ray photoelectron spectroscopy (XPS) was used to confirm the extent of reaction. The results are shown in Table 1.

**Table 1. Atomic ratios (chalcogen (i.e. Se or S) to Zinc) for window layer stacks reacted with H2S or H2Se as obtained via X-ray photoelectron spectroscopy.**

| Gas | Sampling depth, Å | chalcogen/Zinc ratio @ ∼ 25°C | chalcogen/Zinc ratio @ ~140°C |
|---|---|---|---|
| H₂S | ∼ 100 | 0.15 | 0.45 |
| H₂S | ∼ 30 | 0.25 | 0.7 |
| | | | |
| H₂Se | ∼ 100 | 0.32 | 0.55 |
| H₂Se | ∼ 30 | 0.43 | 0.83 |

The data show that the reaction is occurring within the near surface region as the sulfur or selenium to zinc ratios increase when the sampling depth decreases. Also, the extent of reaction is higher for H2Se as the Se/Zn ratio approaches the theoretical maximum of 1. Optical absorbance of the reacted films was compared to an un-reacted control sample showing that the optical properties of the stack is unaffected by the reaction with the hydrogen sulfide and hydrogen selenide.

The reacted and control films were placed in an environmental chamber maintained at 85°C and 85% relative humidity (RH) and the Hall resistivity of the films was measured at various time intervals. At each time interval three replicate measurements were obtained. Table 2 shows that the reaction does provide some beneficial protective effect in that the increase in resistivity of the films is substantially less for the reacted films.

**Table 2. Mean Hall resistivity at t = 0h hours and t = 48 hours for window layer films exposed to 85°C/85% RH environment.**

| Film treatment | Hall resistivity at t=0 hours (Ω-cm x 10⁻⁴) | Hall resistivity at t=48 hours (Ω-cm x 10-4) | Increase (%) |
|---|---|---|---|
| None (control) | 3.63 | 5.63 | 55 |
| H2S | 3.57 | 4.61 | 29 |
| H2Se | 3.45 | 4.79 | 39 |

### Example 2

Indium tin oxide was coated onto glass substrates. The coatings were then treated with hydrogen sulfide at 0.1 mbar and 140°C for 39 minutes. The film was analyzed using angle-resolved XPS at take-off angles of 90, 30, and 15 degrees corresponding to analysis depth of 10, 5, and 3 nm, respectively. The results show that the metal to oxygen mole ratio at each depth is about 0.7 while the sulfur to metal ratio is just under 0.1.

### Example 3

Example 2 was repeated using hydrogen selenide rather than hydrogen sulfide. The results show that the metal to oxygen ratio is about 0.6 at 3 and 5 nm and 3.7 at 10 nm, indicating more reaction at the top levels, while the selenium to metal ratio is from about 0.3 at 10 nm and about 0.4 at 3 and 5 nm.

### Example 4

Example 2 was repeated but on a coating of zinc oxide rather than indium tin oxide. The results show that the metal to oxygen mole ratio at each depth is about 0.5 to 0.7 while the sulfur to metal ratio is from 0.4 to 0.7. This compares to a metal to oxygen ratio of about 0.8 to 0.9 for untreated zinc oxide films.

### Example 5

Example 3 was repeated but on a coating of zinc oxide rather than indium tin oxide, The results show that the metal to oxygen ratio is about 0.4 to 0.6, while the selenium to metal ratio is from about 0.3 to about 0.4.

## Claims

1. A method comprising providing a structure having a backside electrode and at least one photoelectrically active layer and depositing metal oxide over the at least one photoelectrically active layer as part of production of an optoelectrically active device and exposing the metal oxide to a reactive agent that reacts with oxide to form a relatively hydrophobic surface

2. The method of claim 1 wherein the optoelectrically active device is a photovoltaic device and the photoelectrically active layer is an absorber.

3. The method of claim 1 or 2 wherein the metal oxide is a zinc oxide or an indium tin oxide.

4. The method of claim 3 wherein the metal oxide is zinc oxide or aluminum doped zinc oxide.

5. The method of any one of the preceding claims where the reactive agent is hydrogen sulfide or hydrogen selenide.

6. An optoelectrically active device made by the method of any one of claims 1-5.

7. A photovoltaic device having an absorber layer and at least one additional layer comprising a metal oxide wherein the surface of the metal oxide layer comprises the reaction product of the metal oxide with a compound that increases the resistance of the layer to moisture while having substantially no effect on the optical or electrical properties of the layer.

8. The device of claim 7 wherein the depth of surface modification is less than 20 nm.

9. The method of claim 2 wherein a buffer layer is formed over the absorber layer prior to depositing the metal oxide.

10. The device of claim 7 further comprising a support, and a backside electrode, the absorber which is a chalcogenide absorber, and a buffer region.

## Patentansprüche

1. Ein Verfahren, beinhaltend das Bereitstellen einer Struktur mit einer Rückseitenelektrode und mindestens einer photoelektrisch aktiven Schicht und das Abscheiden von Metalloxid über die mindestens eine photoelektrisch aktive Schicht als Teil der Produktion einer optoelektrisch aktiven Vorrichtung und das Aussetzen des Metalloxids gegenüber einem reaktionsfähigen Mittel, das mit dem Oxid reagiert, um eine relativ hydrophobe Oberfläche zu bilden.

2. Verfahren gemäß Anspruch 1, wobei die optoelektrisch aktive Vorrichtung eine photovoltaische Vorrichtung ist und die photoelektrisch aktive Schicht ein Absorber ist.

3. Verfahren gemäß Anspruch 1 oder 2, wobei das Metalloxid ein Zinkoxid oder ein Indiumzinnoxid ist.

4. Verfahren gemäß Anspruch 3, wobei das Metalloxid Zinkoxid oder aluminiumdotiertes Zinkoxid ist.

5. Verfahren gemäß einem der vorhergehenden Ansprüche, wobei das reaktionsfähige Mittel Wasserstoffsulfid oder Wasserstoffselenid ist.

6. Eine durch das Verfahren gemäß einem der Ansprüche 1-5 hergestellte optoelektrisch aktive Vorrichtung.

7. Eine photovoltaische Vorrichtung mit einer Absorberschicht und mindestens einer zusätzlichen Schicht, die ein Metalloxid beinhaltet, wobei die Oberfläche der Metalloxidschicht das Reaktionsprodukt des Metalloxids mit einer Verbindung beinhaltet, welche die Widerstandsfähigkeit der Schicht gegen Feuchtigkeit erhöht, während sie im Wesentlichen keine Auswirkung auf die optischen oder elektrischen Eigenschaften der Schicht hat.

8. Vorrichtung gemäß Anspruch 7, wobei die Tiefe der Oberflächenmodifizierung weniger als 20 nm beträgt.

9. Verfahren gemäß Anspruch 2, wobei vor dem Abscheiden des Metalloxids eine Pufferschicht über der Absorberschicht gebildet wird.

10. Vorrichtung gemäß Anspruch 7, die ferner einen Träger und eine Rückseitenelektrode, den Absorber, der ein Chalkogenidabsorber ist, und eine Pufferregion beinhaltet.

## Revendications

1. Un procédé comprenant la fourniture d'une structure ayant une électrode en face arrière et au moins une couche photoélectriquement active et le dépôt d'oxyde métallique sur la au moins une couche photoélectriquement active dans le cadre de la production d'un dispositif optoélectriquement actif et l'exposition de l'oxyde métallique à un agent réactif qui réagit avec l'oxyde pour former une surface relativement hydrophobe.

2. Le procédé de la revendication 1, le dispositif optoélectriquement actif étant un dispositif photovoltaïque et la couche photoélectriquement active étant un absorbeur.

3. Le procédé de la revendication 1 ou 2, l'oxyde métallique étant un oxyde de zinc ou un oxyde d'indium et d'étain.

4. Le procédé de la revendication 3, l'oxyde métallique étant un oxyde de zinc ou un oxyde de zinc dopé à l'aluminium.

5. Le procédé de n'importe laquelle des revendications précédentes, l'agent réactif étant le sulfure d'hydrogène ou le séléniure d'hydrogène.

6. Un dispositif optoélectriquement actif obtenu par le procédé de n'importe laquelle des revendications 1-5.

7. Un dispositif photovoltaïque ayant une couche d'absorbeur et au moins une couche supplémentaire comprenant un oxyde métallique, la surface de la couche d'oxyde métallique comprenant le produit de la réaction entre l'oxyde métallique et un composé qui augmente la résistance de la couche à l'humidité tout en n'ayant substantiellement aucun effet sur les propriétés optiques ou électriques de la couche.

8. Le dispositif de la revendication 7, la profondeur de la modification de la surface étant inférieure à 20 nm.

9. Le procédé de la revendication 2, une couche tampon étant formée sur la couche d'absorbeur avant le dépôt de l'oxyde métallique.

10. Le dispositif de la revendication 7, qui comprend en outre un support et une électrode en face arrière, l'absorbeur qui est un absorbeur de type chalcogénure et une région tampon.
